# EUROPÄISCHE PATENTSCHRIFT

(11) **EP 4 416 449 B1**
(45) Veröffentlichungstag und Bekanntmachung des Hinweises auf die Patenterteilung: **29.07.2026**
(21) Anmeldenummer: 22782742.5
(22) Anmeldetag: 28.09.2022
(51) Int. Cl.: F28F 1/02, F28F 1/04, F28F 1/40, F28F 3/02, F28F 3/12, H05K 7/20

(54) **KÜHLRIPPE EINES FLUIDDURCHSTRÖMBAREN KÜHLERS ZUM KÜHLEN EINER LEISTUNGSELEKTRONIK**
COOLING FIN OF A COOLER, THROUGH WHICH FLUID CAN FLOW, FOR COOLING POWER ELECTRONICS
AILETTE DE REFROIDISSEMENT DE REFROIDISSEUR, PAR LEQUEL UN FLUIDE PEUT S'ÉCOULER, POUR LE REFROIDISSEMENT DE L'ÉLECTRONIQUE DE PUISSANCE

(30) Priorität: 13.10.2021 DE 102021211544
(43) Veröffentlichungstag der Anmeldung: 21.08.2024
(73) Patentinhaber: Robert Bosch GmbH, 70442 Stuttgart (DE)
(72) Erfinder: KIENLE, Wolfram, 71106 Magstadt (DE); BECK, Max Florian, 71665 Vaihingen an der Enz (DE); LORENZ, Marco, 71254 Ditzingen (DE)
(86) Internationale Anmeldenummer: PCT/EP2022/076984
(87) Internationale Veröffentlichungsnummer: WO 2023/061758

(56) Entgegenhaltungen:
- EP-A1- 3 842 726
- CN-B- 105 241 294
- US-A- 1 828 477
- US-A1- 2012 006 523
- US-A1- 2019 080 985
- US-A1- 2019 366 876
- US-A1- 2021 130 002

## Beschreibung

### Stand der Technik

Die vorliegende Erfindung betrifft eine Kühlrippe eines fluiddurchströmbaren Kühlers zum Kühlen einer Leistungselektronik. Insbesondere bezieht sich die Erfindung auf eine Kühlrippe, durch die eine optimierte Kühlung einer Leistungselektronik ermöglicht wird. Ferner betrifft die Erfindung einen fluiddurchströmbaren Kühler mit einer, insbesondere genau einer, derartigen Kühlrippe sowie eine Anordnung, die eine Leistungselektronik und einen derartigen Kühler umfasst.

Leistungshalbleiter in der Leistungselektronik führen hohe elektrische Ströme. Zusammen mit Schaltverlusten sind die daraus resultierenden Leitverluste ursächlich für eine hohe Verlustwärmeleistung, welche auf einer sehr kleinen Fläche abgeführt werden muss. Die maximal zulässige Halbleitertemperatur ist dabei versagenskritisch, weshalb eine Minimierung des thermischen Widerstands zwischen Halbleiter und Kühlmittel von zentraler Bedeutung ist. Zur effizienten Kühlung werden die Leistungssubstrate auf fluiddurchströmbaren Kühler appliziert. Diese Kühler bestehen aus Aluminium-, AlSiC- oder Kupferlegierungen. Im Kühlerinneren sind Pins oder Rippen zur Vergrößerung der wärmeübertragenden Oberfläche und zur Intensivierung des Wärmeübergangs angeordnet. Zum Zweck eines geringen Wärmewiderstands zwischen einem Leistungssubstrat, insbesondere einem AMB/DBC-Leistungssubstrat (AMB: active metal braze; DBC: direct copper bonding), und Kühler wird das Leistungssubstrat mittels eines Weichlotprozesses, wahlweise auch eines Sinterprozesses auf den Kühler gefügt. Dazu sind diese Kühler gegebenenfalls oberflächenbeschichtet mit für einen Weichlötprozess oder einen Sinterprozess geeigneten Materialien. In der Automobiltechnik sind häufig Aluminiumkühler, auch AlSiC- oder Kupferkühler, welche aus mehreren Bauteilen bestehen, die insbesondere durch einen Hartlötprozess gefügt werden, bekannt. Häufig werden in den fluiddurchströmbaren Kühlern Berippungen aus gestanzten Blechen realisiert. Existierende Rippen-Geometrien erfüllen nicht die Anforderungen an einen fluiddurchströmbaren Kühler zum Kühlen einer Leistungselektronik. Im Wesentlichen ist die thermische Performance bestimmt durch den Wärmeübergang zwischen Fluid und Rippenoberfläche, die Rippenoberfläche und den Rippenwirkungsgrad. Die US 2019/080985 A1, US 2019/366876 A1, EP 3 842 726 A1, auf welcher der Oberbegriff des Anspruchs 1 basiert, US 1 828 477 A. US 2021/130002 A1, US 2012/006523 A1 und CN 105 241 294 B offenbaren fluiddurchströmbare Kühler.

### Offenbarung der Erfindung

Anspruch 1 definiert die Erfindung. Die abhängige Ansprüche definieren bevorzugte Weiterbildungen der Erfindung.

Die erfindungsgemäße Kühlrippe eines fluiddurchströmbaren Kühlers zum Kühlen einer Leistungselektronik weist den Vorteil auf, dass eine optimale Kühlung der Leistungselektronik ermöglicht wird. Insbesondere kann durch die Kühlrippe ein gutes Verhältnis zwischen thermischer Performance der Kühlrippe zu verursachtem Druckverlust im Kühler erzielt werden. Somit eignet sich die erfindungsgemäße Kühlrippe besonders für den Einsatz in fluiddurchströmbaren Kühlern für hochleistungselektronische Anwendungen. Dies wird dadurch erreicht, dass die Kühlrippe eines fluiddurchströmbaren Kühlers zum Kühlen einer Leistungselektronik ein sich in einer Wiederholungsrichtung periodisch wiederholendes Profil umfasst, wobei die Wiederholungsrichtung senkrecht zu einer Erstreckungsrichtung des Profils ist. Es sei angemerkt, dass im Rahmen der Erfindung der Begriff "Profil" insbesondere ein Element, insbesondere ein blechförmiges Element, bezeichnet, dessen Querschnitt über seine gesamte Länge gleichbleibend ist. Die Richtung der Länge des Profils kann als Längsrichtung des Profils bezeichnet werden und entspricht der Erstreckungsrichtung des Profils. Insbesondere entspricht die Erstreckungsrichtung des Profils einer Durchströmungsrichtung.

Die Durchströmungsrichtung entspricht insbesondere einer Hauptströmungsrichtung eines als Kühlmittel verwendeten Fluides, das durch mindestens einen Durchgangskanal strömt, der zumindest durch das sich wiederholende Profil gebildet ist. Dabei ist die Hauptströmungsrichtung insbesondere die Richtung, in der das Fluid hauptsächlich strömt, d.h. die Richtung, in der eine Geschwindigkeitskomponente des Fluides größer als eine Geschwindigkeitskomponente des Fluides in einer zur Wiederholungsrichtung parallelen Richtung ist. Die Hauptströmungsrichtung entspricht vorzugsweise einer Einführungsrichtung des Fluides in den fluiddurchströmbaren Kühler. Die Wiederholungsrichtung entspricht insbesondere einer Breitenrichtung des Kühlers. Die Kühlrippe dient als oberflächenvergrößernde, strömungsführende und wärmeübergangserhöhende Struktur, wodurch eine erhöhte Wärmeabfuhr und somit auch eine verbesserte Kühlung einer Leistungselektronik erreicht werden kann. Die Kühlrippe kann vorzugsweise in einem Stanz- und/oder Rollformprozess zur idealen Oberflächenausnutzung bei höchstem Rippenwirkungsgrad erzeugt werden. Es ist aber auch möglich, dass zum selben Zweck die Kühlrippe je nach Form durch einen Extrusionsprozess hergestellt wird.

Die Unteransprüche zeigen bevorzugte Weiterbildungen der Erfindung.

Vorzugsweise wiederholt sich das Profil eine ganzzahlige oder nicht ganzzahlige Anzahl von Malen. Das heißt, dass bei einer ganzzahligen Anzahl von Wiederholungsmalen des Profils die Kühlrippe einem ganzzahligen Vielfachen des sich periodisch wiederholenden Profils entspricht. Auf der anderen Seite bedeutet eine nicht ganzzahlige Anzahl von Wiederholungsmalen, dass die Kühlrippe kein ganzzahliges Vielfaches des sich periodischen wiederholenden Profils ist. Wie viele Male sich das Profil wiederholt, hängt in vorteilhafter Weise von einer Breite der Leistungselektronik, insbesondere einer Leistungselektronik-Baueinheit, ab, die durch einen die Kühlrippe umfassenden Kühler gekühlt werden soll.

Vorzugsweise weist die Kühlrippe mindestens einen Durchgangskanal, insbesondere eine Mehrzahl von Durchgangskanälen, auf. Der mindestens eine Durchgangskanal ist zumindest teilweise durch das sich wiederholende Profil gebildet. Durch den mindestens einen Durchgangskanal strömt das als Kühlmittel verwendete Fluid, auf das über die Kühlrippe durch die Leistungselektronik erzeugte Wärme übertragen wird und durch das diese abgeführt wird.

Nach einer ersten vorteilhaften Ausgestaltung der Erfindung ist das sich periodisch wiederholende Profil ein Wellenprofil. Insbesondere ist die Kühlrippe aus einem sich periodisch wiederholenden Wellenprofil ausgebildet. Dadurch kann eine große Oberfläche der Kühlrippe und somit eine verbesserte Kühlleistung erzielt werden, ohne dass die Kühlrippe in der Wiederholungsrichtung zu groß wird. Die Kühlrippe kann bei dieser Ausgestaltung vorzugsweise mittels eines Stanz- und/oder Rollformprozesses hergestellt werden.

Es sei angemerkt, dass der Begriff "Wellenprofil" jedes Profil bezeichnet, das einen Querschnitt in der Form einer Welle aufweist, wobei die Welle jede beliebige Form haben kann, solange diese einen Bereich mit maximaler Höhe und einen Bereich mit minimaler Höhe umfasst. Das heißt insbesondere, dass die Welle nicht unbedingt als Kurve ausgebildet sein muss, sondern sie kann auch nur geradlinige Abschnitte oder eine Kombination aus gekrümmten und geradlinigen Abschnitten umfassen. Das heißt, dass im Rahmen der Erfindung sich das Wellenprofil der Kühlrippe in der Wiederholungsrichtung wiederholt und in der Erstreckungsrichtung erstreckt. Es ist zu verstehen, dass das sich periodisch wiederholende Wellenprofil ein in der Wiederholungsrichtung größeres Wellenprofil bildet, welches einen Querschnitt aufweist, der aus den einzelnen Querschnitten des vorgenannten, sich wiederholenden Wellenprofils zusammengebildet ist. Im Rahmen der Erfindung kann die Kühlrippe somit insbesondere ein Kühlrippen-Wellenprofil umfassen, welches dem vorgenannten größeren Wellenprofil entspricht.

Vorzugsweise ist die Kühlrippe mäanderförmig ausgebildet. Mit anderen Worten weist ein Querschnitt der Kühlrippe vorzugsweise die Form eines Mäanders auf. Im Rahmen der Erfindung ist ein Mäander insbesondere eine Welle, die geradlinige oder im Wesentlichen geradlinige Abschnitte umfasst, die senkrecht oder im Wesentlichen senkrecht zueinanderstehen. Mit anderen Worten sind die Abschnitte zueinander derart angeordnet, dass rechtwinklige oder im Wesentlichen rechtwinklige Umlenkungen zwischen benachbarten bzw. direkt miteinander verbundenen Abschnitten ausgebildet sind. Die Formulierung "im Wesentlichen senkrecht" bedeutet insbesondere eine Abweichung von maximal 10 Grad, bevorzugt von maximal 8 Grad, von der senkrechten Position.

Dabei weist das sich wiederholende Wellenprofil bzw. eine Wiederholung des Wellenprofils vorzugsweise einen ersten Steg, einen zweiten Steg, einen dritten Steg und einen vierten Steg auf. Der erste Steg und zweite Steg können als Schenkel bezeichnet werden. Der erste Steg und zweite Steg verlaufen in einer Höhenrichtung, die senkrecht zur Wiederholungsrichtung steht, wobei der dritte Steg und der vierte Steg parallel zur Wiederholungsrichtung verlaufen. Der erste Steg und der zweite Steg sind vorzugsweise über den dritten Steg miteinander verbunden, wobei der vierte Steg vorzugsweise mit dem zweiten Steg verbunden ist. Dabei sind in vorteilhafter Weise Durchgangskanäle zwischen benachbarten Stegen gebildet. Insbesondere sind Durchgangskanäle abwechselnd durch einen ersten Steg, einen benachbarten zweiten Steg und einen benachbarten dritten Steg sowie durch einen ersten Steg, einen benachbarten zweiten Steg und einen benachbarten vierten Steg definiert.

Es ist zu verstehen, dass aufgrund der Wiederholung des sich wiederholenden Wellenprofils sich auch der erste Steg und/oder der zweite Steg und/oder der dritte Steg und/oder der vierte Steg in vorteilhafter Weise wiederholt/wiederholen. Das heißt, dass die Kühlrippe eine Mehrzahl von ersten Stegen und/oder zweiten Stegen und/oder dritten Stegen und/oder vierten Stegen aufweisen kann.

Es sei angemerkt, dass ein Bereich des Wellenprofils mit maximaler Höhe insbesondere den dritten Steg umfasst. Entsprechend umfasst ein Bereich des Wellenprofils mit minimaler Höhe insbesondere den vierten Steg.

Der dritte Steg ist in vorteilhafter Weise der Leistungselektronik zugewandt, wobei der vierte Steg der Leistungselektronik abgewandt ist.

Ein erster Steg, der mit einem dritten Steg verbunden ist, kann vorzugsweise in den dritten Steg mit einem Abrundungsradius (Innen- und Außenradius) übergehen. Ein dritter Steg, der mit einem zweiten Steg verbunden ist, kann vorzugsweise in den zweiten Steg mit einem Abrundungsradius (Innen- und Außenradius) übergehen. Diese Abrundungsradien können bevorzugt gleich sein und gemeinsam als erster Abrundungsradius bezeichnet werden.

Ein zweiter Steg, der mit einem vierten Steg verbunden ist, kann vorzugsweise in den vierten Steg mit einem Abrundungsradius (Innen- und Außenradius) übergehen. Ein vierter Steg, der mit einem ersten Steg verbunden ist, kann vorzugsweise in den vierten Steg mit einem Abrundungsradius (Innen- und Außenradius) übergehen. Diese Abrundungsradien können bevorzugt gleich sein und gemeinsam als zweiter Abrundungsradius bezeichnet werden.

Vorteilhafterweise ist der zweite Abrundungsradius größer als der erste Abrundungsradius, insbesondere doppelt so groß wie der erste Abrundungsradius. In vorteilhafter Weise ist der erste Abrundungsradius gleich groß wie eine Profilstärke der Kühlrippe.

Bei der Ausgestaltung des Profils als Wellenprofil kann vorzugsweise eine Teilung der Kühlrippe zwischen 1,8 mm und 2,5 mm, vorzugweise zwischen 1,9 mm und 2,1 mm, insbesondere 2 mm, betragen. Die Teilung der Kühlrippe entspricht dabei der Periode, mit der sich das periodisch wiederholende Wellenprofil zum Bilden der Kühlrippe wiederholt.

Nach einer zweiten vorteilhaften Ausgestaltung der Erfindung ist das sich periodisch wiederholende Profil ein kreuzförmiges Profil. Diese Ausgestaltung der Kühlrippe ist vorteilhaft, da das kreuzförmige Profil zum einen einfach herzustellen ist und zum anderen eine große Oberfläche zum Übertragen von Wärme auf das als Kühlmittel verwendete Fluid aufweist. Insbesondere ist die Kühlrippe aus einem sich periodisch wiederholenden kreuzförmigen Profil ausgebildet. Das kreuzförmige Profil weist vorzugsweise einen ersten Steg, einen zweiten Steg und einen dritten Steg auf, wobei der erste Steg und der zweite Steg jeweils in einem senkrechten Winkel zum dritten Steg stehen und sich vom dritten Steg herauserstrecken. Es ist zu verstehen, dass die Stege zueinander derart angeordnet sind, dass das Profil die Form eines Kreuzes hat. In vorteilhafter Weise erstreckt sich der dritte Steg in der Wiederholungsrichtung des sich wiederholenden Profils. Der zuvor beschriebene mindestens eine Durchgangskanal umfasst dabei vorzugsweise mindestens einen Durchgangskanal zwischen benachbarten ersten Stegen und einen Durchgangskanal zwischen benachbarten zweiten Stegen. Insbesondere ist mindestens ein Durchgangskanal durch benachbarte erste Stege und benachbarte dritte Stege definiert, wobei mindestens ein Durchgangskanal durch benachbarte zweite Stege und benachbarte dritte Stege definiert. Vorzugsweise ist die Kühlrippe gemäß dieser Ausgestaltung mittels eines Extrusionsprozesses hergestellt.

Es ist zu verstehen, dass aufgrund der Wiederholung des sich wiederholenden kreuzförmigen Profils sich auch der erste Steg und/oder der zweite Steg und/oder der dritte Steg in vorteilhafter Weise wiederholt/wiederholen. Das heißt, dass die Kühlrippe eine Mehrzahl von ersten Stegen und/oder zweiten Stegen und/oder dritten Stegen aufweisen kann.

Bevorzugt kann die Kühlrippe ferner einen vierten Steg umfassen, der parallel zum dritten Steg verläuft und mit einem Endbereich jedes ersten Stegs oder jedes zweiten Stegs verbunden ist. Der vierte Steg erstreckt sich in vorteilhafter Weise in der Erstreckungsrichtung des Profils.

Alternativ kann die Kühlrippe ferner bevorzugt einen vierten Steg und einen fünften Steg umfassen, die parallel zum dritten Steg verlaufen. Dabei ist der vierte Steg mit einem Endbereich jedes ersten Stegs verbunden, wobei der fünfte Steg mit einem Endbereich jedes zweiten Stegs verbunden ist. Der vierte Steg und fünfte Steg erstrecken sich in vorteilhafter Weise in der Erstreckungsrichtung des Profils.

Vorteilhafterweise verläuft/verlaufen der vierte Steg und/oder der fünfte Steg in der Wiederholungsrichtung des sich wiederholenden Profils. Der zuvor erwähnte mindestens eine Durchgangskanal umfasst in vorteilhafter Weise mindestens einen Durchgangskanal zwischen benachbarten ersten Stegen und mindestens einen Durchgangskanal zwischen benachbarten zweiten Stegen.

Nach einer vorteilhaften Variante der zweiten Ausgestaltung der Erfindung kann ein Maß des ersten Stegs in der Wiederholungsrichtung gleich mit einem Maß des zweiten Stegs in der Wiederholungsrichtung sein. Somit kann die Kühlrippe einfach hergestellt werden.

Nach einer alternativen vorteilhaften Variante der zweiten Ausgestaltung der Erfindung kann ein Maß des ersten Stegs in der Wiederholungsrichtung größer als ein Maß des zweiten Stegs in der Wiederholungsrichtung sein. Somit kann eine Wärmeabfuhr durch die Kühlrippe weiter verbessert werden. Dabei ist es von Vorteil, wenn der erste Steg des kreuzförmigen Profils eingerichtet ist, der Leistungselektronik zugewandt zu sein, wobei der zweite Steg des kreuzförmigen Profils eingerichtet ist, der Leistungselektronik abgewandt zu sein. Das heißt, dass bei dieser Ausgestaltung der erste Steg eingerichtet ist, näher zur Leistungselektronik zu sein als der zweite Steg. Durch die unterschiedlichen Maße der ersten Stege und zweiten Stege kann die Strömung, insbesondere die Strömungsgeschwindigkeit, des als Kühlmittel verwendeten Fluides derart beeinflusst werden, dass ein gewünschter Wärmeübergangskoeffizient des Fluides erzielt wird.

Das Maß des ersten Stegs bzw. des zweiten Stegs in der Wiederholungsrichtung entspricht insbesondere einer Materialstärke des ersten Stegs bzw. des zweiten Stegs.

Nach einer dritten vorteilhaften Ausgestaltung der Erfindung ist das sich periodisch wiederholende Profil ein V-förmiges Profil, das einen ersten Steg und einen zweiten Steg aufweist. Dabei kann die Kühlrippe vorzugsweise ferner einen dritten Steg aufweisen, wobei der dritte Steg in der Wiederholungsrichtung verläuft und derart angeordnet ist, dass pro Wiederholung des Profils durch den ersten Steg, den zweiten Steg und den dritten Steg ein dreieckförmiger Durchgangskanal gebildet ist. Der dritte Steg erstreckt sich in vorteilhafter Weise in der Erstreckungsrichtung des Profils. Alternativ kann die Kühlrippe bevorzugt ferner einen dritten Steg und einen vierten Steg aufweisen, wobei der dritte Steg und der vierte Steg in der Wiederholungsrichtung verlaufen und derart angeordnet sind, dass in der Kühlrippe dreieckförmige Durchgangskanäle gebildet sind. Der dritte Steg und der vierte Steg erstrecken sich in vorteilhafter Weise in der Erstreckungsrichtung des Profils. Vorzugsweise ist die Kühlrippe gemäß der dritten vorteilhaften Ausgestaltung mittels eines Extrusionsprozesses hergestellt.

Es ist zu verstehen, dass aufgrund der Wiederholung des sich wiederholenden V-förmigen Profils sich auch der erste Steg und/oder der zweite Steg in vorteilhafter Weise wiederholt/wiederholen. Das heißt, dass die Kühlrippe eine Mehrzahl von ersten Stegen und/oder zweiten Stegen aufweisen kann.

Durch die Formen der Kühlrippen gemäß den zuvor beschriebenen vorteilhaften Ausgestaltungen der Erfindung kann insbesondere ein gutes Verhältnis einer thermischen Performance zu einem durch die Kühlrippe verursachte Druckverlust im Kühler ermöglicht werden.

Besonders bevorzugt kann eine Höhe der Kühlrippe zwischen 5 mm und 8 mm, vorzugsweise zwischen 5,9 mm und 6,1 mm, betragen. Die Höhe wird in vorteilhafter Weise in einer Höhenrichtung gemessen, die senkrecht zur Wiederholungsrichtung und Erstreckungsrichtung des Profils steht.

Besonders bevorzugt kann eine Materialstärke der Kühlrippe zwischen 0,3 mm und 0,6 mm, vorzugsweise zwischen 0,35 mm und 0,45 mm, betragen. Die Materialstärke der Kühlrippe entspricht bei der Kühlrippe gemäß der zuvor beschriebenen ersten Ausgestaltung insbesondere einer Profilstärke des sich wiederholenden Wellenprofils. Bei der Kühlrippe gemäß der zuvor beschriebenen zweiten Ausgestaltung umfasst die Materialstärke der Kühlrippe insbesondere eine Profilstärke des sich wiederholenden kreuzförmigen Profils und insbesondere auch eine Materialstärke des vierten Stegs und/oder des fünften Stegs. Bei der Kühlrippe gemäß der zuvor beschriebenen dritten Ausgestaltung umfasst die Materialstärke der Kühlrippe insbesondere eine Profilstärke des V-förmigen Profils und/oder eine Materialstärke des vierten Stegs und/oder des fünften Stegs.

Besonders bevorzugt kann ein lichtes Maß zwischen benachbarten Stegen der Kühlrippe in der Wiederholungsrichtung zwischen 0,6 mm und 1,2 mm, vorzugsweise zwischen 0,85 mm und 0,95 mm, betragen. Bei der ersten vorteilhaften Ausgestaltung ist das lichte Maß zwischen benachbarten Stegen insbesondere ein lichtes Maß zwischen einem ersten Steg und einem benachbarten zweiten Steg. Bei der Kühlrippe gemäß der zuvor beschriebenen zweiten vorteilhaften Ausgestaltung umfasst das lichte Maß zwischen benachbarten Stegen insbesondere ein lichtes Maß zwischen benachbarten ersten Stegen und/oder ein lichtes Maß zwischen benachbarten zweiten Stegen. Bei der Kühlrippe gemäß der zuvor beschriebenen dritten vorteilhaften Ausgestaltung entspricht das lichte Maß zwischen benachbarten Stegen insbesondere einem maximalen lichten Maß zwischen einem ersten Steg und einem benachbarten zweiten Steg.

In vorteilhafter Weise ist die Kühlrippe einstückig/einteilig ausgebildet.

Die Kühlrippe ist vorzugsweise aus einem Material ausgebildet und/oder mit einem Material beschichtet, welches einen Wärmeleitfähigkeitskoeffizienten aufweist, der größer als 150 W/(m·K) ist. In vorteilhafter Weise kann die Kühlrippe aus Aluminium ausgebildet oder mit Aluminium oder Nickel beschichtet sein.

Die vorliegende Erfindung betrifft weiterhin einen fluiddurchströmbaren Kühler zum Kühlen einer Leistungselektronik, der eine zuvor beschriebene Kühlrippe umfasst.

Der fluiddurchströmbare Kühler umfasst vorzugsweise genau eine zuvor beschriebene Kühlrippe und einen Kühlkanal. Dabei ist die Kühlrippe im Kühlkanal angeordnet. Eine Länge der Kühlrippe in der Erstreckungsrichtung des sich wiederholenden Profils ist gleich mit einem Maß des Kühlkanals in der Erstreckungsrichtung des sich wiederholenden Profils.

Vorzugsweise umfasst der fluiddurchströmbare Kühler ein Gehäuse. Das Gehäuse kann vorzugsweise aus mindestens zwei Metallteilen, insbesondere Aluminiumteilen, ausgebildet sein, die miteinander verbunden sind und den Kühlkanal definieren. Der Kühlkanal entspricht dabei insbesondere einem Innenraum des Gehäuses.

Weiter bevorzugt sind am Gehäuse direkt ein Einlass und ein Auslass für ein als Kühlmittel verwendete Fluid angeordnet.

Vorzugsweise entspricht ein Bereich der Kühlrippe zumindest einem Teil des Gehäuses des Kühlers. Das heißt mit anderen Worten, dass ein Bereich der Kühlrippe zumindest als Teil des Gehäuses des Kühlers ausgebildet ist. In vorteilhafter Weise entspricht der vierte Steg und - je nach Ausbildung der Kühlrippe - insbesondere auch der fünfte Steg bei der Kühlrippe gemäß der zuvor beschriebenen vorteilhaften vierten Ausgestaltung jeweils zumindest einem Teil des Gehäuses. Insbesondere kann der vierte Steg teilweise oder vollständig einem Metallteil aus den mindestens zwei Metallteilen des Gehäuses entsprechen. Wenn bei der Kühlrippe ein vierter Steg sowie ein fünfter Steg vorgesehen sind, kann der vierte Steg teilweise oder vollständig einem ersten Metallteil aus den mindestens zwei Metallteilen des Gehäuses und der fünfte Steg einem zweiten Metallteil aus den mindestens zwei Metallteilen des Gehäuses entsprechen.

Ferner betrifft die vorliegende Erfindung eine Leistungselektronik-Anordnung, die einen zuvor beschriebenen fluiddurchströmbaren Kühler und eine Leistungselektronik umfasst. Hierbei ist die Leistungselektronik am Kühler angeordnet. Dadurch ist die Leistungselektronik mittels des Kühlers kühlbar. Insbesondere ist die Leistungselektronik am Kühler fixiert.

Vorzugsweise kann die Leistungselektronik (genau) eine Leistungselektronik-Baueinheit oder mehrere Leistungselektronik-Baueinheiten umfassen. Die Leistungselektronik-Baueinheiten können auf einer oder beiden Seiten des fluiddurchströmbaren Kühlers bzw. dessen Gehäuses angeordnet sein. Mit anderen Worten kann der fluiddurchströmbare Kühler auf einer oder auf beiden Seiten mit Leistungselektronik-Baueinheiten bestückt sein.

Die Leistungselektronik kann vorzugsweise mindestens eine erste Leistungselektronik-Baueinheit und eine zweite Leistungselektronik-Baueinheit umfassen. In der Hauptströmungsrichtung des als Kühlmittel verwendeten Fluides ist die erste Leistungselektronik-Baueinheit vorzugsweise vor der zweiten Leistungselektronik-Baueinheit angeordnet. Ferner bevorzugt kann die Leistungselektronik eine dritte Leistungselektronik-Baueinheit umfassen. Dabei ist vorzugsweise die dritte Leistungselektronik-Baueinheit in der Hauptströmungsrichtung des Fluides nach der zweiten Leistungselektronik-Baueinheit angeordnet.

Eine Leistungselektronik-Baueinheit kann im Rahmen der Erfindung insbesondere auch als Leistungsmodul bezeichnet sein. Die Leistungselektronik-Baueinheit umfasst vorzugsweise eine Leiterplatte und/oder Leiterbahnen und/oder einen oder mehrere Leistungshalbleiter.

### Kurze Beschreibung der Zeichnungen

Nachfolgend werden Ausführungsbeispiele der Erfindung unter Bezugnahme auf die begleitende Zeichnung im Detail beschrieben, wobei gleiche oder funktional gleiche Bauteile mit den gleichen Bezugszeichen bezeichnet sind. In der Zeichnung ist:
- Figur 1: eine schematische vereinfachte Schnittansicht einer erfindungsgemäßen Leistungselektronik-Anordnung mit einer Leistungselektronik und einem eine Kühlrippe aufweisenden fluiddurchströmbaren Kühler gemäß einem ersten Ausführungsbeispiel der Erfindung,
- Figur 2: eine schematische perspektivische Ansicht der Kühlrippe gemäß dem ersten Ausführungsbeispiel der Erfindung,
- Figur 3: eine schematische Vorderansicht einer Kühlrippe gemäß einem zweiten Ausführungsbeispiel der Erfindung,
- Figur 4: eine schematische Vorderansicht einer Kühlrippe gemäß einem dritten Ausführungsbeispiel der Erfindung,
- Figur 5: eine schematische Vorderansicht einer Kühlrippe gemäß einem vierten Ausführungsbeispiel der Erfindung,
- Figur 6: eine schematische Vorderansicht einer Kühlrippe gemäß einem fünften Ausführungsbeispiel der Erfindung,
- Figur 7: eine schematische Vorderansicht einer Kühlrippe gemäß einem sechsten Ausführungsbeispiel der Erfindung,
- Figur 8: eine schematische vereinfachte Schnittansicht einer Leistungselektronik-Anordnung gemäß einem siebten Ausführungsbeispiel der vorliegenden Erfindung,
- Figur 9: eine schematische vereinfachte Schnittansicht einer Leistungselektronik-Anordnung gemäß einem achten Ausführungsbeispiel der vorliegenden Erfindung, und
- Figur 10: eine schematische vereinfachte Schnittansicht einer Leistungselektronik-Anordnung gemäß einem neunten Ausführungsbeispiel der vorliegenden Erfindung.

### Ausführungsformen der Erfindung

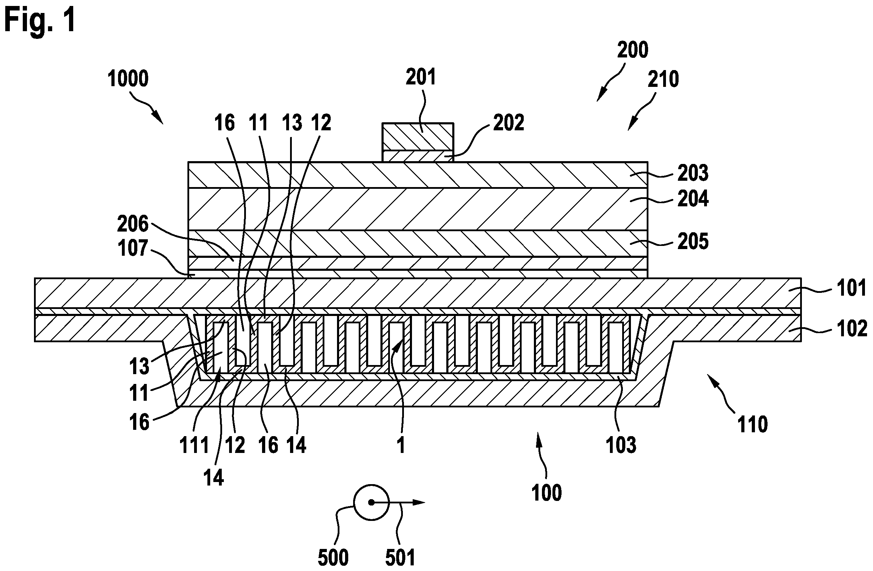

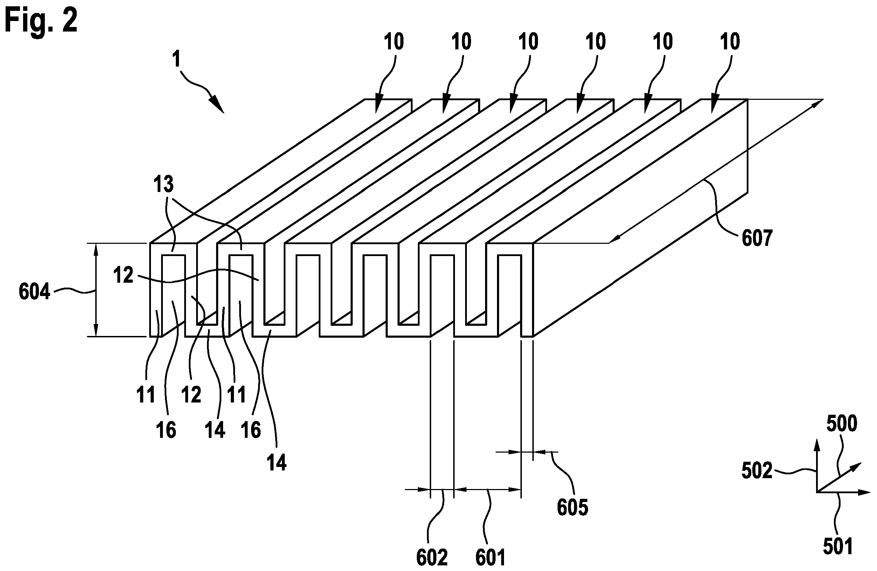

Nachfolgend wird unter Bezugnahme auf die Figuren 1 und 2 eine erfindungsgemäße Leistungselektronik-Anordnung 1000 mit einer Leistungselektronik 200 und einem Kühler 100 gemäß einem ersten Ausführungsbeispiel der Erfindung beschrieben.

Wie aus Figur 1 ersichtlich ist, umfasst die Leistungselektronik 200 eine Leistungselektronik-Baueinheit 210, die auch als Leistungsmodul bezeichnet werden kann. Die Leistungselektronik-Baueinheit 210 weist eine Leiterplatte 204, Leiterbahnen 203, 205 und Leistungshalbleiter 201 auf. Die Leiterbahnen 203, 205 sind insbesondere als Kupferleiterbahnen ausgebildet, wobei die Leiterplatte 204 vorzugsweise aus Keramik ausgebildet ist.

Die Leistungshalbleiter 201 sind mittels einer Schicht 202 auf die Leiterbahn 203 aufgebracht. Dabei ist die Schicht 202 insbesondere als Lot- oder Sinterschicht ausgebildet.

Die Leiterbahnen 203, 205 zusammen mit der Leiterplatte 204 bilden ein Leistungssubstrat. Das Leistungssubstrat ist mittels einer durch einen Weichlötprozess oder einen Sinterprozess erzeugten Schicht 206, die somit entsprechend eine Weichlotschicht oder Sinterschicht ist, auf den Kühler 100, insbesondere auf ein erstes Metallteil 101 eines Gehäuses 110 des Kühlers 100, gefügt.

Das Gehäuse 110 des Kühlers 100 umfasst ferner ein zweites Metallteil 102, welches mit dem ersten Metallteil 101 mittels einer Schicht 103, die insbesondere als Hartlotschicht ausgebildet ist, verbunden ist. Sowohl das erste Metallteil 101 als auch das zweite Metallteil 102 sind vorzugsweise Aluminiumsteile.

Aus Figur 1 erkennt man ferner, dass das erste Metallteil 101 ein Oberteil und das zweite Metallteil 102 ein Unterteil des Gehäuses 110 ist. Das erste Metallteil 101 ist der Leistungselektronik-Baueinheit 210 zugewandt, wobei das zweite Metallteil 102 der Leistungselektronik-Baueinheit 210 abgewandt ist. Weiterhin ist in diesem Ausführungsbeispiel das erste Metallteil 101 plattenförmig ausgebildet, wobei das zweite Metallteil 102 einen plattenförmigen Bereich und einen im Querschnitt trapezförmigen Bereich aufweist. Es ist aber auch möglich, dass das erste Metallteil 101 und das zweite Metallteil 102 andere Formen aufweisen. Das zweite Metallteil 102 kann in vorteilhafter Weise durch einen Tiefziehprozess hergestellt werden.

Zwischen der Schicht 206 und dem Kühler 100, insbesondere dem ersten Metallteil 101, befindet sich in vorteilhafter Weise eine Vermittlungsschicht 107, welche fest mit dem ersten Metallteil 101 verbunden ist und eine Benetzung der Schicht 206 erlaubt. Die Vermittlungsschicht 107 ist ein optionales Merkmal der Leistungselektronik-Anordnung 1000 und kann insbesondere entweder als separates Teil oder als Teil des Gehäuses 110 des Kühlers 100 betrachtet werden.

Durch das erste Metallteil 101 und das zweite Metallteil 102, die im zusammengefügten Zustand das Gehäuse 110 des Kühlers 100 bilden, ist ein Innenraum definiert, welcher als Kühlkanal 111 des Kühlers 100 dient.

Im Kühlkanal 111 ist genau eine Kühlrippe 1 angeordnet, die als oberflächenvergrößernde, für ein als Kühlmittel verwendete Fluid strömungsführende und wärmeübergangserhöhende Struktur dient. Die Kühlrippe 1 ist in vorteilhafter Weise mittels der Schicht 103 zum ersten Metallteil 101 und zweiten Metallteil 102 gefügt.

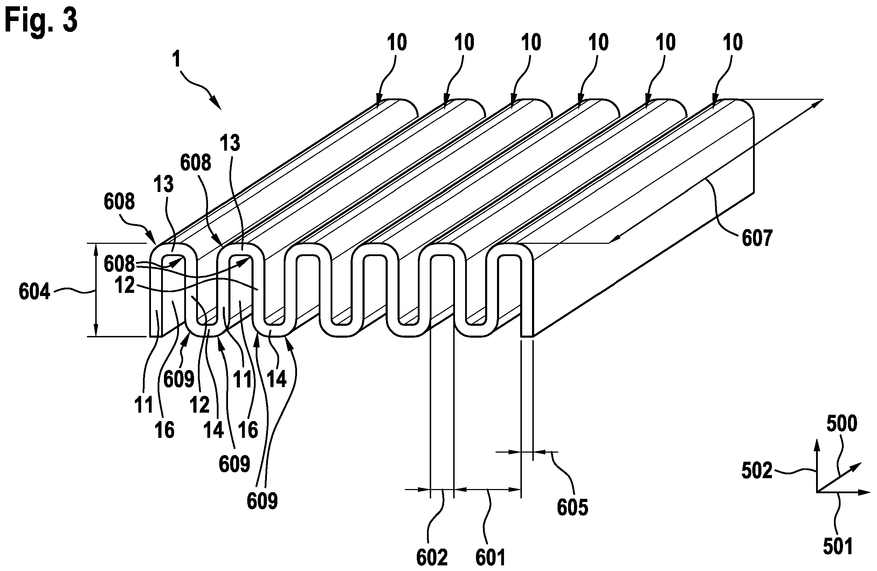

Die Kühlrippe 1 ist aus einem sich in einer Wiederholungsrichtung 501 periodisch wiederholenden Profil 10 gebildet. Die Wiederholungsrichtung 501 steht senkrecht zu einer Erstreckungsrichtung 500 des Profils 10 und entspricht insbesondere einer Breitenrichtung des Kühlers 100. Die Erstreckungsrichtung 500 ist die Richtung, in der sich das sich wiederholende Profil 10 bzw. die Kühlrippe 1 als Einheit erstreckt. Dabei entspricht die Erstreckungsrichtung 500 einer Durchströmungsrichtung 500, insbesondere einer Hauptströmungsrichtung, eines als Kühlmittel verwendeten Fluides, wenn dieses durch den Kühlkanal 111, insbesondere durch Durchgangskanäle 16 strömt (Figuren 1 und 3), die durch das sich wiederholende Profil 10 gebildet sind. Die einzige Kühlrippe 1 erstreckt sich in der Erstreckungsrichtung 500 über eine gesamte Länge des Kühlkanals 111 des Kühlers 100 in der Erstreckungsrichtung 500. Das heißt, dass eine Länge 607 der Kühlrippe 1 gleicht mit der gesamten Länge des Kühlkanals 111 ist.

Das sich wiederholende Profil 10 ist in diesem Ausführungsbeispiel ein Wellenprofil. Insbesondere ist die Kühlrippe 1 mäanderförmig ausgebildet. Die Kühlrippe 1 ist einstückig/einteilig ausgebildet und vorzugsweise mittels eines Stanzprozesses hergestellt.

Das sich wiederholende Wellenprofil bzw. jede Wiederholung des Wellenprofils umfasst einen ersten Steg 11, einen zweiten Steg 12, einen dritten Steg 13 und einen vierten Steg 14.

Der erste Steg 11 und zweite Steg 12 des sich wiederholenden Wellenprofils verlaufen in einer Höhenrichtung 502, die senkrecht zur Wiederholungsrichtung 501 und Erstreckungsrichtung 500 steht, wobei der dritte Steg 13 und der vierte Steg 14 parallel zur Wiederholungsrichtung 501 verlaufen. Somit umfasst die Kühlrippe 1 eine Mehrzahl von ersten Stegen 11, zweiten Stegen 12, dritten Stegen 13 und vierten Stegen 14. Ein erster Steg 11 ist mit einem benachbarten zweiten Steg 12 über einen dritten Steg 13 oder einen vierten Steg 14 verbunden. Ein Übergang von einem der Stege 11 bis 14 in einen benachbarten Steg ist rechtwinklig (nicht abgerundet) ausgebildet.

Dabei sind Durchganskanäle 16 zwischen benachbarten Stegen 11, 12 gebildet. Ein lichtes Maß 602 zwischen benachbarten Stegen 11, 12 in der Wiederholungsrichtung 501, welches dem Maß dem entsprechenden gebildeten Durchgangskanal 16 entspricht, beträgt zwischen 0,6 mm und 1,2 mm, vorzugsweise zwischen 0,85 mm und 0,95 mm.

Eine Teilung 601 der Kühlrippe 1 kann zwischen 1,8 mm und 2,5 mm, vorzugweise zwischen 1,9 mm und 2,1 mm, betragen. Die Teilung 601 der Kühlrippe 1 entspricht dabei der Periode, mit der sich das periodisch wiederholende Profil 10 zum Bilden der Kühlrippe 1 wiederholt.

Eine Höhe 604 der Kühlrippe 1 zwischen 5 mm und 8 mm, vorzugsweise zwischen 5,9 mm und 6,1 mm, betragen.

Ferner kann eine Materialstärke 605 der Kühlrippe 1 zwischen 0,3 mm und 0,6 mm, vorzugsweise zwischen 0,35 mm und 0,45 mm, betragen. Die Materialstärke 605 der Kühlrippe 1 entspricht dabei einer Profilstärke des sich wiederholenden Wellenprofils bzw. einer Materialstärke der Stege 11 bis 14.

Durch die Kühlrippe 1 kann während des Betriebs der Leistungselektronik-Baueinheit 210 erzeugte Wärme in effizienter Weise von der Leistungselektronik-Baueinheit 210 zuerst auf das erste Metallteil 101 und von dort auf ein die Kühlrippe 10 durchströmendes Fluid übertragen und abgeführt werden. Ferner wird ein optimales Verhältnis zwischen thermischer Performance zum im Kühler 100 verursachtem Druckverlust ermöglicht.

Um eine gute Wärmeübertragung zu erzielen und gleichzeitig eine einfache Herstellung zu ermöglichen, ist die Kühlrippe 1 in vorteilhafter Weise aus Aluminium ausgebildet. Alternativ kann die Kühlrippe 1 mit einer Aluminiumschicht versehen sein. Es ist auch möglich, dass die Kühlrippe 1 mit Nickel beschichtet ist. Es ist allerdings auch möglich, dass andere wärmleitfähige Materialien für die Kühlrippe 1 und/oder deren Schicht benutzt werden, die insbesondere einen Wärmeleitfähigkeitskoeffizienten größer als 150 W/(m·K) aufweisen.

Der Kühler 100 kann ferner bevorzugt Kühlmittelstutzen aufweisen, die ebenfalls mittels eines Hartlots im Fertigungsschritt der Verbindung der beiden Metallteile 101,102 miteinander gefügt werden können.

Figur 3 bezieht sich auf eine Kühlrippe 1 gemäß einem zweiten Ausführungsbeispiel der Erfindung.

Der Aufbau der Kühlrippe 1 gemäß dem zweiten Ausführungsbeispiel ist grundsätzlich identisch mit dem Aufbau der Kühlrippe 1 gemäß dem ersten Ausführungsbeispiel.

Der einzige Unterschied besteht in der Form der Übergänge zwischen benachbarten Stegen.

Insbesondere gehen bei der Kühlrippe 1 gemäß dem zweiten Ausführungsbeispiel die ersten Stege 11, die jeweils mit einem dritten Steg 13 verbunden sind, mit einem ersten Abrundungsradius (Innen- und Außenradius) in den entsprechenden dritten Steg 13 über. Ferner gehen die dritten Stege 13, die jeweils mit einem zweiten Steg 12 verbunden sind, mit dem ersten Abrundungsradius 608 (Innen- und Außenradius) in den entsprechenden zweiten Steg 12 über. Die zweiten Stege 12, die jeweils mit einem vierten Steg 14 verbunden sind, gehen mit einem zweiten Abrundungsradius 609 (Innen- und Außenradius) in den entsprechenden vierten Steg 14 über. Des Weiteren gehen die vierten Stege 14, die jeweils mit einem ersten Steg 11 verbunden sind, mit dem zweiten Abrundungsradius 609 (Innen- und Außenradius) in den entsprechenden ersten Steg 11 über.

Der zweite Abrundungsradius 609 ist größer als der erste Abrundungsradius 608, insbesondere doppelt so groß wie der erste Abrundungsradius 608. In vorteilhafter Weise ist der erste Abrundungsradius 608 gleich groß wie die Profilstärke 605 der Kühlrippe 1.

Die Kühlrippe 1 gemäß dem zweiten Ausführungsbeispiel kann die Kühlrippe 1 gemäß dem ersten Ausführungsbeispiel im Kühler 100 aus Figur 1 ersetzen. Dabei ist die Kühlrippe 1 im Kühlkanal 111 des Kühlers 100 derart angeordnet, dass die dritten Stege 13 näher zur Leistungselektronik-Baueinheit 210 als die vierten Stege 14 sind.

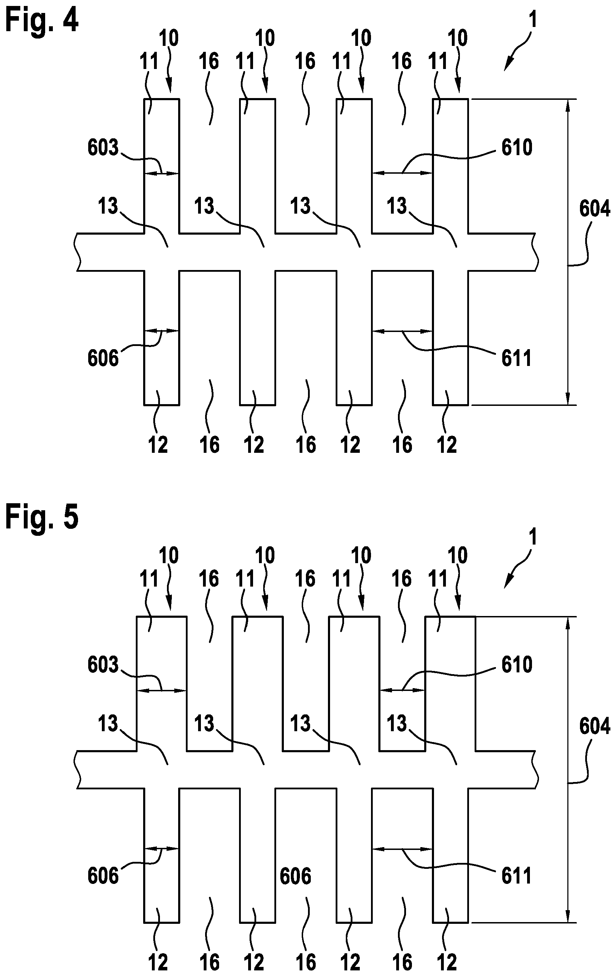

Figur 4 bezieht sich auf eine Kühlrippe 1 gemäß einem dritten Ausführungsbeispiel der Erfindung.

Hier ist die Kühlrippe 1 aus einem sich periodisch wiederholenden Profil 10 ausgebildet, welches ein kreuzförmiges Profil ist. Vorzugsweise ist die Kühlrippe 1 ein Extrusionsprodukt.

Das kreuzförmige Profil weist einen ersten Steg 11, einen zweiten Steg 12 und einen dritten Steg 13 auf. Dabei stehen der erste Steg 11 und der zweite Steg 12 jeweils in einem senkrechten Winkel zum dritten Steg 30 und erstrecken sich vom dritten Steg 13 heraus. Der dritte Steg 13 erstreckt sich in der Wiederholungsrichtung 501 des sich wiederholenden Profils 10. Somit weist die Kühlrippe 1 eine Mehrzahl von ersten Stegen 11, zweiten Stegen 12 und dritten Stegen 13 auf.

Zwischen benachbarten ersten Stegen 11 sind Durchgangskanäle 16 für das als Kühlmittel verwendete Fluid gebildet, wobei zwischen benachbarten zweiten Stegen 12 weitere Durchgangskanäle 16 für das Fluid gebildet sind.

Ein Maß (Materialstärke) 603 des ersten Stegs 11 in der Wiederholungsrichtung 501 ist gleich mit einem Maß (Materialstärke) 606 des zweiten Stegs 12 in der Wiederholungsrichtung 501. Somit ist auch ein lichtes Maß 610 zwischen benachbarten ersten Stegen 11 in der Wiederholungsrichtung 501 gleich mit einem lichten Maß 611 zwischen benachbarten zweiten Stegen 12 in der Wiederholungsrichtung 501. Insbesondere beträgt das lichte Maß 610 bzw. 611 zwischen 0,6 mm und 1,2 mm, vorzugsweise zwischen 0,85 mm und 0,95 mm. Sowohl das lichte Maß 610 als auch das lichte Maß 611 entsprechen dem Maß dem jeweiligen gebildeten Durchgangskanal 16 in der Wiederholungsrichtung 501.

Eine Höhe 604 der Kühlrippe 1 beträgt zwischen 5 mm und 8 mm, vorzugsweise zwischen 5,9 mm und 6,1 mm.

Figur 5 bezieht sich auf eine Kühlrippe 1 gemäß einem vierten Ausführungsbeispiel der Erfindung.

Die Kühlrippe 1 gemäß dem vierten Ausführungsbeispiel der Erfindung unterscheidet sich von derjenigen gemäß dem dritten Ausführungsbeispiel dadurch, dass das Maß (Materialstärke) 603 der ersten Stege 11 in der Wiederholungsrichtung 501 größer als das Maß (Materialstärke) 606 der zweiten Stege 12 in der Wiederholungsrichtung 501 ist. Somit ist auch das lichte Maß 610 zwischen benachbarten ersten Stegen 11 in der Wiederholungsrichtung 501 kleiner als das lichte Maß 611 zwischen benachbarten zweiten Stegen 12 in der Wiederholungsrichtung 501.

Die Kühlrippe 1 gemäß dem dritten Ausführungsbeispiel der Erfindung kann im Gehäuse 110 des Kühlers 100 aus Figur 1 vorgesehen sein. Insbesondere wird dann die Kühlrippe 1 im Kühlkanal 111 derart angeordnet, dass die ersten Stege 11 der Leistungselektronik 200 zugewandt sind, wobei die zweiten Stege 12 der Leistungselektronik 200 abgewandt sind.

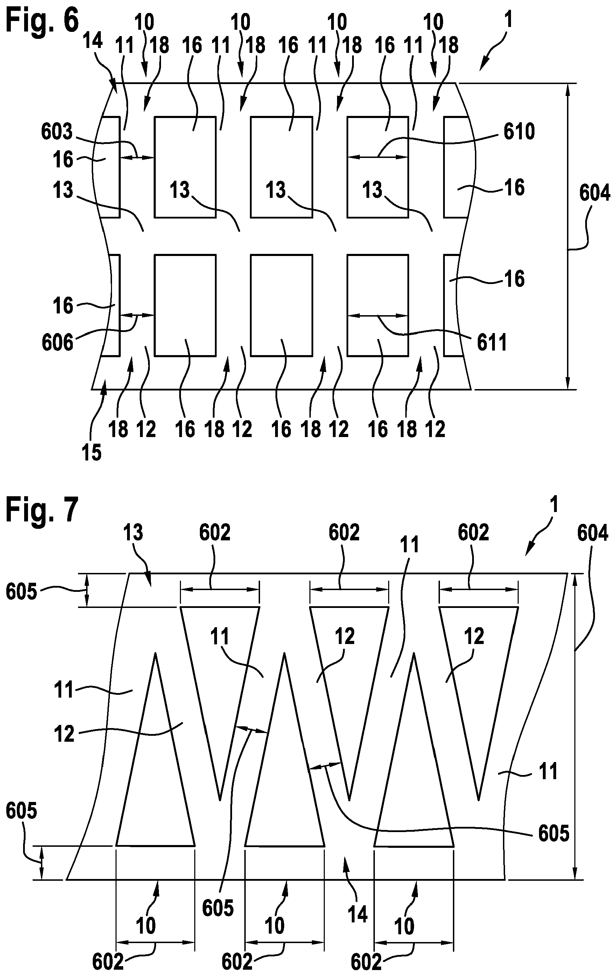

Figur 6 zeigt eine Kühlrippe 1 gemäß einem fünften Ausführungsbeispiel der vorliegenden Erfindung.

Die Kühlrippe 1 gemäß dem fünften Ausführungsbeispiel unterscheidet sich von derjenigen gemäß dem dritten Ausführungsbeispiel dadurch, dass die Kühlrippe 1 hier zusätzlich einen vierten Steg 14 und einen fünften Steg 15 umfasst, die parallel zum dritten Steg 13 verlaufen. Somit verlaufen der vierte Steg 14 und der fünfte Steg 15 parallel zur Wiederholungsrichtung 501 und erstrecken sich in der Erstreckungsrichtung 500.

Der vierte Steg 14 ist an Endbereichen 18 der ersten Stege 11 angeordnet und mit diesen verbunden. Der fünfte Steg 15 ist an Endbereichen 18 der zweiten Stege 12 angeordnet und mit diesen verbunden.

Durch diese Ausbildung der Kühlrippe 1 sind Durchgangskanäle 16 für das als Kühlmittel verwendete Fluid zwischen benachbarten ersten Stegen 11 und dem vierten Steg 14 sowie zwischen benachbarten zweiten Stegen 12 und dem fünften Steg 15 gebildet.

Die Kühlrippe 1 gemäß dem fünften Ausführungsbeispiel der Erfindung kann die Kühlrippe 1 gemäß dem ersten Ausführungsbeispiel ersetzen. Ferner ist es möglich, dass der vierte Steg 14 das erste Metallteil 101 und der fünfte Steg 15 das zweite Metallteil 102 des Gehäuses 100 aus Figur 1, vollständig oder teilweise, bilden.

Figur 7 zeigt eine Kühlrippe 1 gemäß einem sechsten Ausführungsbeispiel der vorliegenden Erfindung.

Hier umfasst die Kühlrippe 1 ein sich periodisch wiederholendes Profil 10, welches ein V-förmiges Profil ist. Vorzugsweise ist die Kühlrippe 1 mittels eines Extrusionsprozesses hergestellt.

Das sich wiederholende V-förmige Profil weist einen ersten Steg 11 und einen zweiten Steg 12, die derart zueinander angeordnet sind, dass das Profil 10 eine V-Form aufweist. Somit umfasst die Kühlrippe 1 eine Mehrzahl von ersten Stegen 11 und zweiten Stegen 12.

Ferner umfasst die Kühlrippe 1 zusätzlich einen dritten Steg 13 und einen vierten Steg 14. Der dritte Steg 13 und der vierte Steg 14 verlaufen in der Wiederholungsrichtung 501 und sind relativ zu den ersten Stegen 11 und den zweiten Stegen 12 derart angeordnet, dass in der Kühlrippe 1 dreieckförmige Durchgangskanäle 16 gebildet sind.

Ein lichtes Maß 602 zwischen benachbarten Stegen 11, 12 in der Wiederholungsrichtung 501 entspricht einem maximalen Maß dem entsprechenden gebildeten Durchgangskanal 16 und beträgt zwischen 0,6 mm und 1,2 mm, vorzugsweise zwischen 0,85 mm und 0,95 mm.

Eine Höhe 604 der Kühlrippe 1 zwischen 5 mm und 8 mm, vorzugsweise zwischen 5,9 mm und 6,1 mm, betragen.

Ferner kann eine Materialstärke 605 der Kühlrippe 1 zwischen 0,3 mm und 0,6 mm, vorzugsweise zwischen 0,35 mm und 0,45 mm, betragen. Die Materialstärke 605 der Kühlrippe 1 entspricht dabei einer Profilstärke des sich wiederholenden Wellenprofils bzw. einer Materialstärke der Stege 11 bis 14.

Die Kühlrippe 1 gemäß dem sechsten Ausführungsbeispiel der Erfindung kann die Kühlrippe 1 gemäß dem ersten Ausführungsbeispiel ersetzen. Ferner ist es möglich, dass der dritte Steg 14 das erste Metallteil 101 und der vierte Steg 14 das zweite Metallteil 102 des Gehäuses 100 aus Figur 1, vollständig oder teilweise, bilden.

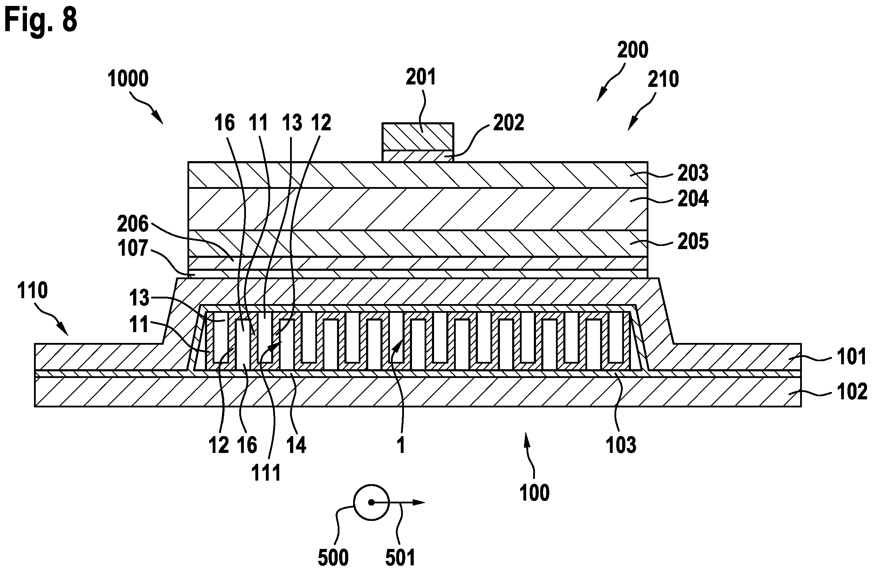

Figur 8 zeigt eine Leistungselektronik-Anordnung 1000 gemäß einem siebten Ausführungsbeispiel der vorliegenden Erfindung.

Die Leistungselektronik-Anordnung 1000 gemäß dem siebten Ausführungsbeispiel unterscheidet sich von derjenigen gemäß dem ersten Ausführungsbeispiel dadurch, dass das erste Metallteil 101, welches als Oberteil und somit der Leistungselektronik-Baueinheit 210 zugewandt ist, einen plattenförmigen Bereich und einen im Querschnitt trapezförmigen Bereich aufweist, wobei das zweite Metallteil 102, welches als Unterteil und somit der Leistungselektronik-Baueinheit 210 zugewandt ist, plattenförmig ausgebildet ist.

Diese Ausbildung des Gehäuses 110 kann im Falle eines Platzmangels in der unmittelbaren Nähe der Leistungselektronik-Baueinheit 210 vorteilhaft sein.

Es sei angemerkt, dass das Gehäuse 110 des Kühlers 100 gemäß dem siebten Ausführungsbeispiel auch mit einer Kühlrippe 1 gemäß einem der Ausführungsbeispiele zwei bis sechs kombiniert werden kann.

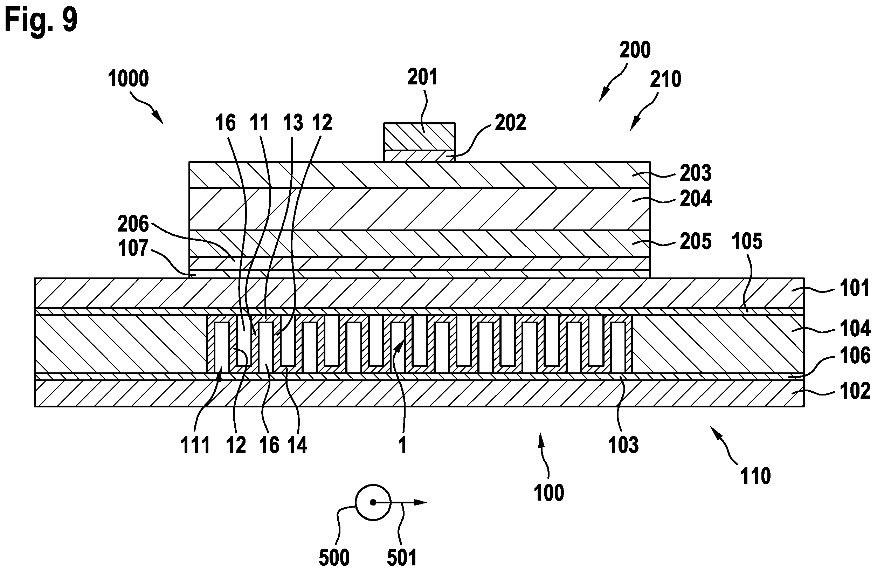

Figur 9 bezieht sich auf eine Leistungselektronik-Anordnung 1000 gemäß einem achten Ausführungsbeispiel der vorliegenden Erfindung.

Analog zur Leistungselektronik-Anordnung 1000 gemäß dem siebten Ausführungsbeispiel, unterscheidet sich die Leistungselektronik-Anordnung 1000 gemäß dem achten Ausführungsbeispiel von derjenigen gemäß dem ersten Ausführungsbeispiel durch die Ausbildung des Gehäuses 110 des Kühlers 100.

Wie aus Figur 9 erkennbar ist, ist neben dem ersten Metallteil 101 und dem zweiten Metallteil 102 ein drittes Metallteil 104 vorgesehen, welches zusammen mit dem ersten Metallteil 101 und dem zweiten Metallteil 102 das Gehäuse 110 des Kühlers 100 bilden. Das dritte Metallteil 104, welches insbesondere auch als Aluminiumteil ausgebildet ist, ist zwischen dem ersten Metallteil 101 und dem zweiten Metallteil 102 angeordnet. Das erste Metallteil 101 ist mittels einer ersten Schicht 105 zum dritten Metallteil 104 gefügt, welches mittels einer zweiten Schicht 106 mit dem zweiten Metallteil 102 verbunden ist. Die erste Schicht 105 und/oder die zweite Schicht 106 ist/sind vorzugsweise jeweils als Hartlotschicht ausgebildet.

Es ist zu verstehen, dass der Kühlkanal 111 durch das erste Metallteil 101, das zweite Metallteil 102 und das dritte Metallteil 104 definiert ist.

Diese Ausbildung des Gehäuses 110 bietet den Vorteil, dass dieses sehr einfach hergestellt werden kann.

Es sei angemerkt, dass das Gehäuse 110 des Kühlers 100 gemäß dem achten Ausführungsbeispiel auch mit einer Kühlrippe 1 gemäß einem der Ausführungsbeispiele zwei bis sechs kombiniert werden kann. Im Falle einer Verwendung der Kühlrippen 1 aus den Figuren 6 oder 7 können auch hier das erste Metallteil 101 und das zweite Metallteil 102 durch die entsprechenden Stege der Kühlrippen ersetzt werden.

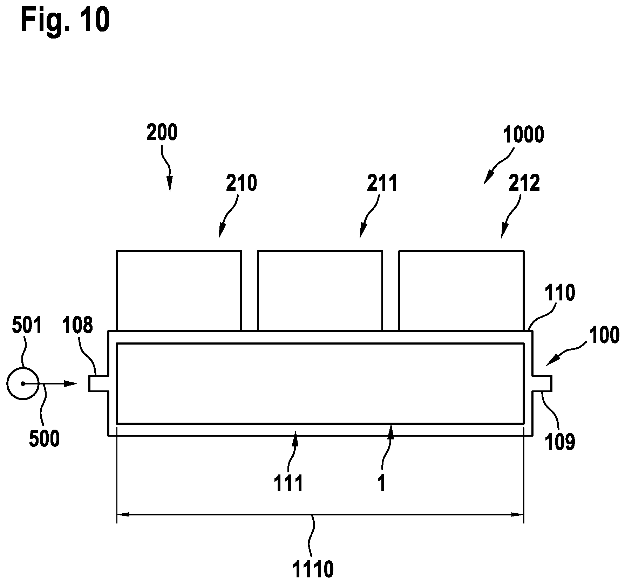

Figur 10 zeigt auf eine Leistungselektronik-Anordnung 1000 gemäß einem neunten Ausführungsbeispiel der vorliegenden Erfindung.

Die Leistungselektronik 200 der Leistungselektronik-Anordnung 1000 gemäß dem neunten Ausführungsbeispiel umfasst eine erste Leistungselektronik-Baueinheit 210, eine zweite Leistungselektronik-Baueinheit 211 und eine dritte Leistungselektronik-Baueinheit 212.

In der Durchströmungsrichtung bzw. der Hauptströmungsrichtung des als Kühlmittel verwendeten Fluides ist die erste Leistungselektronik-Baueinheit 210 vor der zweiten Leistungselektronik-Baueinheit 211 angeordnet, die wiederum in der Durchströmungsrichtung 500 vor der dritten Leistungselektronik-Baueinheit 212 angeordnet ist. Die Durchströmungsrichtung entspricht in vorteilhafter Weise einer Richtung von einem Einlass 108 zu einem Auslass 109 des Kühlers 100.

Die Kühlrippe 1 ist allen Leistungselektronik-Baueinheiten 210, 211, 212 zugeordnet. Das heißt, dass Wärme, die durch die Leistungselektronik-Baueinheiten 210, 211, 212 während deren Betriebs erzeugt wird, auf die einzige Kühlrippe 1 und von da auf das durchströmende Fluid übertragen wird. Dazu erstreckt sich die Kühlrippe 1 in deren Erstreckungsrichtung 500 über eine gesamte Länge 1110 des Kühlkanals 111 des Kühlers 100.

## Patentansprüche

1. Kühlrippe (1) eines fluiddurchströmbaren Kühlers (100) zum Kühlen einer Leistungselektronik (200), umfassend ein sich in einer Wiederholungsrichtung periodisch wiederholendes Profil (10), wobei die Wiederholungsrichtung (501) senkrecht zu einer Erstreckungsrichtung (500) des Profils (10) ist, **dadurch gekennzeichnet, dass**:
eine Höhe (604) der Kühlrippe (1) zwischen 5 mm und 8 mm, vorzugsweise zwischen 5,9 mm und 6,1 mm, beträgt, und
eine Materialstärke (605; 603, 606) der Kühlrippe (1) zwischen 0,3 mm und 0,6 mm, vorzugsweise zwischen 0,35 mm und 0,45 mm, beträgt, und
ein lichtes Maß (602; 610; 611) zwischen benachbarten Stegen (11, 12) der Kühlrippe (1) in der Wiederholungsrichtung (501) zwischen 0,6 mm und 1,2 mm, vorzugsweise zwischen 0,85 mm und 0,95 mm, beträgt.

2. Kühlrippe (1) nach Anspruch 1, wobei sich das Profil (10) eine ganzzahlige oder nicht ganzzahlige Anzahl von Malen wiederholt.

3. Kühlrippe (1) nach Anspruch 1 oder 2, wobei das sich periodisch wiederholende Profil (10) ein Wellenprofil ist, wobei die Kühlrippe (1) vorzugsweise mäanderförmig ausgebildet ist.

4. Kühlrippe nach Anspruch 3, wobei eine Teilung (601) der Kühlrippe (1) zwischen 1,8 mm und 2,5 mm, vorzugweise zwischen 1,9 mm und 2,1 mm, beträgt,

5. Kühlrippe (1) nach Anspruch 1 oder 2, wobei das sich periodisch wiederholende Profil (10) ein kreuzförmiges Profil ist, welches einen ersten Steg (11), einen zweiten Steg (12) und einen dritten Steg (13) aufweist, wobei der erste Steg (11) und der zweite Steg (12) jeweils in einem senkrechten Winkel zum dritten Steg (13) stehen und sich vom dritten Steg (13) herauserstrecken.

6. Kühlrippe (1) nach Anspruch 5, wobei die Kühlrippe (1) ferner einen vierten Steg (14) umfasst, der parallel zum dritten Steg (13) verläuft und mit einem Endbereich (18) jedes ersten Stegs (11) oder jedes zweiten Stegs (12) verbunden ist oder wobei die Kühlrippe (1) ferner einen vierten Steg (14) und einen fünften Steg (15) umfasst, die parallel zum dritten Steg (13) verlaufen, wobei der vierte Steg (14) mit einem Endbereich (18) jedes ersten Stegs (11) und der fünfte Steg (15) mit einem Endbereich (18) jedes zweiten Stegs (12) verbunden sind.

7. Kühlrippe (1) nach Anspruch 5 oder 6, wobei ein Maß des ersten Stegs (11) in der Wiederholungsrichtung (501) der Kühlrippe (1) größer als ein Maß des zweiten Stegs (12) in der Wiederholungsrichtung (501) ist.

8. Kühlrippe (1) nach Anspruch 1 oder 2, wobei das sich periodisch wiederholende Profil (10) ein V-förmiges Profil ist, das einen ersten Steg (11) und einen zweiten Steg (12) aufweist, und
vorzugsweise wobei:
die Kühlrippe (1) ferner einen dritten Steg (13) aufweist, wobei der dritte Steg (13) in der Wiederholungsrichtung (501) verläuft und derart angeordnet ist, dass pro Wiederholung des Profils (10) durch den ersten Steg (11), den zweiten Steg (12) und den dritten Steg (13) ein dreieckförmiger Durchgangskanal (16) gebildet ist, oder
die Kühlrippe (1) ferner einen dritten Steg (13) und einen vierten Steg (14) aufweist, wobei der dritte Steg (13) und der vierte Steg (14) in der Wiederholungsrichtung (501) verlaufen und derart angeordnet sind, dass in der Kühlrippe (1) dreieckförmige Durchgangskanäle (16) gebildet sind.

9. Fluiddurchströmbarer Kühler (100) zum Kühlen einer Leistungselektronik (200), umfassend eine Kühlrippe (1) nach einem der vorherigen Ansprüche, vorzugsweise wobei:
der Kühler (100) einen Kühlkanal (111) und genau eine Kühlrippe (1) nach einem der vorherigen Ansprüche umfasst, die im Kühlkanal (111) angeordnet ist und eine Länge (607) der Kühlrippe (1) in der Erstreckungsrichtung (500) gleich mit einem Maß (1110) des Kühlkanals (111) in der Erstreckungsrichtung (500) ist.

10. Fluiddurchströmbarer Kühler (100) nach Anspruch 9, wobei ein Bereich (14, 15; 13, 14) der Kühlrippe (1) einem Teil (101, 102) eines Gehäuses (110) des Kühlers (100) entspricht.

11. Leistungselektronik-Anordnung (1000), umfassend eine Leistungselektronik (200) und einen fluiddurchströmbaren Kühler (100) nach Anspruch 9 oder 10, wobei die Leistungselektronik (200) am Kühler (100) angeordnet, insbesondere fixiert, ist.

## Claims

1. Cooling fin (1) of a cooler (100) through-flowable by fluid for cooling power electronics (200), comprising a profile (10) which repeats periodically in a repetition direction, wherein the repetition direction (501) is perpendicular to an extent direction (500) of the profile (10),
**characterized in that**:
a height (604) of the cooling fin (1) is between 5 mm and 8 mm, preferably between 5.9 mm and 6.1 mm, and
a material thickness (605; 603, 606) of the cooling fin (1) is between 0.3 mm and 0.6 mm, preferably between 0.35 mm and 0.45 mm, and
a clearance (602; 610; 611) between adjacent webs (11, 12) of the cooling fin (1) in the repetition direction (501) is between 0.6 mm and 1.2 mm, preferably between 0.85 mm and 0.95 mm.

2. Cooling fin (1) according to Claim 1, wherein the profile (10) repeats an integer or non-integer number of times.

3. Cooling fin (1) according to Claim 1 or 2, wherein the periodically repeating profile (10) is a wave profile, wherein the cooling fin (1) is preferably of meandering form.

4. Cooling fin according to Claim 3, wherein a pitch (601) of the cooling fin (1) is between 1.8 mm and 2.5 mm, preferably between 1.9 mm and 2.1 mm.

5. Cooling fin (1) according to Claim 1 or 2, wherein the periodically repeating profile (10) is a cross-shaped profile which has a first web (11), a second web (12) and a third web (13), wherein the first web (11) and the second web (12) are each positioned at a right angle to the third web (13) and extend out from the third web (13).

6. Cooling fin (1) according to Claim 5, wherein the cooling fin (1) further comprises a fourth web (14) which extends parallel to the third web (13) and which is connected to an end region (18) of each first web (11) or of each second web (12), or wherein the cooling fin (1) further comprises a fourth web (14) and a fifth web (15) which extend parallel to the third web (13), wherein the fourth web (14) is connected to an end region (18) of each first web (11) and the fifth web (15) is connected to an end region (18) of each second web (12).

7. Cooling fin (1) according to Claim 5 or 6, wherein a dimension of the first web (11) in the repetition direction (501) of the cooling fin (1) is greater than a dimension of the second web (12) in the repetition direction (501).

8. Cooling fin (1) according to Claim 1 or 2, wherein the periodically repeating profile (10) is a V-shaped profile which has a first web (11) and a second web (12), and
preferably wherein:
the cooling fin (1) further has a third web (13), wherein the third web (13) extends in the repetition direction (501) and is arranged in such a way that, for each repetition of the profile (10), a triangular passage channel (16) is formed by the first web (11), the second web (12) and the third web (13), or
the cooling fin (1) further has a third web (13) and a fourth web (14), wherein the third web (13) and the fourth web (14) extend in the repetition direction (501) and are arranged in such a way that triangular passage channels (16) are formed in the cooling fin (1).

9. Cooler (100) through-flowable by fluid for cooling power electronics (200), comprising a cooling fin (1) according to one of the preceding claims, preferably wherein:
the cooler (100) comprises a cooling channel (111) and exactly one cooling fin (1) according to one of the preceding claims that is arranged in the cooling channel (111), and a length (607) of the cooling fin (1) in the extent direction (500) is equal to a dimension (1110) of the cooling channel (111) in the extent direction (500).

10. Cooler (100) through-flowable by fluid according to Claim 9, wherein a region (14, 15; 13, 14) of the cooling fin (1) corresponds to a part (101, 102) of a housing (110) of the cooler (100).

11. Power-electronics arrangement (1000) comprising power electronics (200) and a cooler (100) through-flowable by fluid according to Claim 9 or 10, wherein the power electronics (200) are arranged on, in particular fixed to, the cooler (100).

## Revendications

1. Ailette de refroidissement (1) d'un refroidisseur (100) pouvant être traversé par un fluide pour le refroidissement d'une électronique de puissance (200), comprenant un profil (10) se répétant périodiquement selon une direction de répétition, la direction de répétition (501) étant perpendiculaire à une direction d'extension (500) du profil (10),
**caractérisée en ce que**
une hauteur (604) de l'ailette de refroidissement (1) est comprise entre 5 mm et 8 mm, de préférence entre 5,9 mm et 6,1 mm, et
une épaisseur de matériau (605; 603, 606) de l'ailette de refroidissement (1) est comprise entre 0,3 mm et 0,6 mm, de préférence entre 0,35 mm et 0,45 mm, et
une distance libre (602 ; 610 ; 611) entre des nervures adjacentes (11, 12) de l'ailette de refroidissement (1) dans la direction de répétition (501) est comprise entre 0,6 mm et 1,2 mm, de préférence entre 0,85 mm et 0,95 mm.

2. Ailette de refroidissement (1) selon la revendication 1, dans laquelle le profil (10) se répète un nombre entier ou non entier de fois.

3. Ailette de refroidissement (1) selon la revendication 1 ou 2, dans laquelle le profil (10) se répétant périodiquement est un profil ondulé, l'ailette de refroidissement (1) étant de manière préférée réalisée sous forme de méandres.

4. Ailette de refroidissement selon la revendication 3, dans laquelle un pas (601) de l'ailette de refroidissement (1) est compris entre 1,8 mm et 2,5 mm, de manière préférée entre 1,9 mm et 2,1 mm,

5. Ailette de refroidissement (1) selon la revendication 1 ou 2, dans laquelle le profil (10) se répétant périodiquement est un profil en forme de croix, lequel présente une première nervure (11), une deuxième nervure (12) et une troisième nervure (13), la première nervure (11) et la deuxième nervure (12) étant chacune disposées à un angle droit par rapport à la troisième nervure (13) et s'étendant à partir de la troisième nervure (13).

6. Ailette de refroidissement (1) selon la revendication 5, dans laquelle l'ailette de refroidissement (1) comprend en outre une quatrième nervure (14), s'étendant parallèlement à la troisième nervure (13) et reliée à une région d'extrémité (18) de chaque première nervure (11) ou de chaque deuxième nervure (12), ou dans laquelle l'ailette de refroidissement (1) comprend en outre une quatrième nervure (14) et une cinquième nervure (15), s'étendant parallèlement à la troisième nervure (13), la quatrième nervure (14) étant reliée à une région d'extrémité (18) de chaque première nervure (11) et la cinquième nervure (15) étant reliée à une région d'extrémité (18) de chaque deuxième nervure (12).

7. Ailette de refroidissement (1) selon la revendication 5 ou 6, dans laquelle une dimension de la première nervure (11) dans la direction de répétition (501) de l'ailette de refroidissement (1) est supérieure à une dimension de la deuxième nervure (12) dans la direction de répétition (501).

8. Ailette de refroidissement (1) selon la revendication 1 ou 2, dans laquelle le profil (10) se répétant périodiquement est un profil en V, lequel présente une première nervure (11) et une deuxième nervure (12), et
de préférence dans laquelle :
l'ailette de refroidissement (1) présente en outre une troisième nervure (13), la troisième nervure (13) s'étendant dans la direction de répétition (501) et étant agencée de telle sorte que, pour chaque répétition du profil (10), un canal de passage de forme triangulaire (16) est formé par la première nervure (11), la deuxième nervure (12) et la troisième nervure (13), ou
l'ailette de refroidissement (1) présente en outre une troisième nervure (13) et une quatrième nervure (14), la troisième nervure (13) et la quatrième nervure (14) s'étendant dans la direction de répétition (501) et étant agencées de telle sorte que des canaux de passage de forme triangulaire (16) sont formés dans l'ailette de refroidissement (1).

9. Refroidisseur (100) pouvant être traversé par un fluide pour le refroidissement d'une électronique de puissance (200), comprenant une ailette de refroidissement (1) selon l'une des revendications précédentes, de préférence dans lequel :
le refroidisseur (100) comprend un canal de refroidissement (111) et exactement une ailette de refroidissement (1) selon l'une des revendications précédentes, laquelle est disposée dans le canal de refroidissement (111), une longueur (607) de l'ailette de refroidissement (1) dans la direction d'extension (500) étant égale à une dimension (1110) du canal de refroidissement (111) dans la direction d'extension (500).

10. Refroidisseur (100) pouvant être traversé par un fluide selon la revendication 9, dans lequel une zone (14, 15 ; 13, 14) de l'ailette de refroidissement (1) correspond à une partie (101, 102) d'un boîtier (110) du refroidisseur (100).

11. Agencement d'électronique de puissance (1000), comprenant une électronique de puissance (200) et un refroidisseur (100) pouvant être traversé par un fluide selon la revendication 9 ou 10, l'électronique de puissance (200) étant disposée, en particulier fixée, sur le refroidisseur (100).
